# EUROPÄISCHE PATENTSCHRIFT

(11) **EP 2 760 263 B1**
(45) Veröffentlichungstag und Bekanntmachung des Hinweises auf die Patenterteilung: **27.03.2024**
(21) Anmeldenummer: 14152625.1
(22) Anmeldetag: 27.01.2014
(51) Int. Cl.: H05K 9/00

(54) **Tragbares elektronisches Gerät mit Schutz vor statischer Aufladung**
Portable electronic device with protection against static charge
Appareil électronique portable doté d'une protection contre la charge électrostatique

(30) Priorität: 29.01.2013 DE 102013201372
(43) Veröffentlichungstag der Anmeldung: 30.07.2014
(73) Patentinhaber: ecom instruments GmbH, 97959 Assamstadt (DE)
(72) Erfinder: Gebert, Werner, 97980 Bad Mergentheim (DE)
(74) Vertreter: Hoffmann Eitle

(56) Entgegenhaltungen:
- DE-B3-102005 046 306
- US-A1- 2003 133 281
- US-A1- 2011 006 953
- US-A1- 2011 050 508

## Beschreibung

Die vorliegende Erfindung betrifft ein tragbares elektronisches Gerät mit einem Schutz vor statischer Aufladung, das insbesondere zur Verwendung in explosionsgefährdeten Bereichen geeignet ist, sowie ein Verfahren zur Herstellung desselben.

### Stand der Technik

Elektrostatische Entladungen können bekanntermaßen beispielsweise durch eine Person hervorgerufen werden, die beim Laufen über einen Teppichboden aufgrund von Reibungselektrizität statisch aufgeladen wurde. Dabei können Spannungen von mehreren tausend Volt erreicht werden. Diese elektrostatische Aufladung führt beispielsweise dann zu Problemen, wenn diese Person mit empfindlicher Elektronik arbeitet, wie zum Beispiel bei der Wartung und Handhabung von Computertechnik.

Genauso wie Personen elektrostatisch aufgeladen werden können, können elektronische Geräte aufgeladen werden, beispielsweise indem eine aufgeladene Person solch ein Gerät anfasst oder das Gerät einfach mit einem Lappen abgewischt wird. Eine elektrostatische Aufladung eines Gehäuses eines elektronischen Geräts kann schon dadurch erfolgen, dass es aus einer Tasche gezogen wird, wodurch Elektronen, negative Ladungen, abgestreift werden können, so dass sich das Gerät auflädt.

Während sich Personen im Alltag lediglich kurz erschrecken, wenn die auf ihnen befindliche Ladung bei Berührung eines geerdeten Objekts, z.B. Heizkörper, abgeleitet wird, kann dies bei der Handhabung von Schaltkreisen der Computertechnik zur Zerstörung von integrierten Schaltungen, insbesondere von MOSFETs, führen.

Weitaus schlimmere Folgen können elektrische Entladungen in explosionsgefährdeten Umgebungen, wie z.B. in Kohlebergwerken, Chemiefabriken, Tankstellen, etc. haben. Dort kann ein durch eine Potenzialdifferenz entstehender Funke oder Durchschlag, d.h. eine elektrostatische Entladung, zu einer Entzündung bzw. Explosion von Gas, wie z.B. Grubengas, führen. Grubengas besteht größtenteils aus Methan und kann leicht entzündet werden. Deshalb ist das Unterdrücken eines durch elektrische Entladung erzeugten Funkens in explosionsgefährdeten Bereichen, wie im Ex-Bereich (Zone 1), von äußerster Wichtigkeit.

Eine Möglichkeit einen gewissen Schutz vor elektrischer Entladung bereitzustellen, besteht darin, elektronische Geräte mit einem antistatischen Gehäuse auszustatten. Jedoch können solche Gehäuse zu einer Beeinträchtigung der Funktion des elektronischen Geräts führen. Diese Gehäuse müssen zuverlässig vor Staub und Nässe schützen sowie auch stabil sein und den verschiedenen Belastungen und Anforderungen im Arbeitsumfeld genügen. Bei elektronischen Geräten, die auf eine Datenübertragung per Funk unter Verwendung einer elektromagnetischen Welle angewiesen sind, führen solche Gehäuse jedoch dazu, dass ausgesandte oder zu empfangende elektromagnetische Wellen stark abgeschwächt werden, was zu Fehlfunktionen oder fehlerhaft empfangenen/gesendeten Daten führen kann.

Die Druckschrift US 2003/133281 A1 beschreibt eine elektronische Vorrichtung mit einer drahtlosen Einheit. Die drahtlose Einheit des elektronischen Geräts dient zur drahtlosen Kommunikation mit einem externen Gerät. Das Gehäuse des elektronischen Geräts weist eine Gehäusebasis und eine Gehäuseabdeckung aus leitendem Material auf.

Antennenelemente sind an den linken und rechten Seitenwänden des Gehäuses zwischen der Gehäusebasis und der Gehäuseabdeckung eingefügt und werden durch Seitenabdeckungen abgedeckt. Eine Seitenabdeckung ist ein Element zur Einstellung eines elektrostatischen Kapazitätskopplungsbetrags zwischen Gehäusebasis, Gehäuseabdeckung und Antennenelement, wobei dieser Betrag durch die Elektrizitätskonstante des Materials eingestellt werden kann.

US 2011/006953 A1 betrifft Antennen für elektronische Geräte und beschreibt mögliche Antennenorte, an welchen ein Antennenfenster für eine Antenne angebracht werden kann. Des Weiteren wird ein Antennenfenster mit mehreren Öffnungen beschrieben.

### Zusammenfassung der Erfindung

Der Erfindung liegt die Aufgabe zugrunde, ein tragbares elektronisches Gerät mit einem Schutz vor statischer Aufladung bereitzustellen, das jedoch in seinen Funktionen nicht eingeschränkt wird.

Diese Aufgabe wird durch ein elektronisches Gerät mit Schutz vor statischer Aufladung und einem Verfahren gemäß den unabhängigen Ansprüchen 1 und 7 gelöst. Vorteilhafte Ausführungsformen sind in den Unteransprüchen beschrieben.

Gemäß einer Ausführungsform umfasst das tragbare elektronische Gerät zur Verwendung in explosionsgefährdeten Bereichen, mit Schutz vor statischer Aufladung ein Sendemodul mit einer Antenne und ein Gehäuse zum Schutz vor statischen Entladungen, das unter anderem das Sendemodul und die Antenne aufnimmt. Das tragbare elektronische Gerät ist dabei derart ausgebildet, dass mindestens ein Teil des Gehäuses eine Rahmenstruktur von Rahmenelementen aus antistatischem Material mit dazwischen befindlichen Bereichen eines anderen Materials aufweist, und die Abstrahlung der Antenne und die Rahmenstruktur derart aufeinander abgestimmt sind, dass eine Hauptstrahlrichtung durch einen Bereich mit anderem Material geht. Dadurch kann ein stabiles vor statischen Entladungen geschütztes Gehäuse für ein tragbares elektronisches Gerät bereitgestellt werden, das die Funktionen des Geräts nicht beeinträchtigt, und insbesondere abzustrahlende bzw. zu empfangende elektromagnetische Wellen nicht wesentlich beeinflusst, indem die Gehäusestruktur auf die Abstrahlung von einer oder mehreren Antennen im Gerät ausgerichtet ist.

Gemäß dieser Ausführungsform umfasst das Gehäuse des tragbaren elektronischen Geräts Bereiche aus dem anderen Material, die maximal 20 cm² groß sind. Bevorzugt sind diese zwischen den Rahmenelementen liegende Bereiche maximal 4 cm² groß. Dadurch können bestimmte Bereiche des Gehäuses des Geräts auf eine Flächengröße reduziert werden, auf der sich nicht genügend Ladungen sammeln können, um eine derartige Entladung zu bewirken, die in einer explosionsgefährdeten Umgebung eine Explosion durch einen Funken hervorrufen könnte.

Gemäß dieser Ausführungsform umfasst das Gehäuse auch mindestens drei Bereiche des anderen, d.h. nichtantistatischen oder weniger antistatischen Materials. Dadurch können Abstrahlungs- bzw. Empfangsfenster im Gehäuse bereitgestellt werden, die eine Abstrahlungscharakteristik der Antenne oder Antennen nicht merklich negativ beeinflusst und die Funktionen des Geräts nicht beeinträchtigt.

Gemäß einer weiteren vorteilhaften Ausführungsform sind mindestens zwei Bereiche an der Rückseite des Geräts und/oder zwei Bereiche an den Seitenflächen des Geräts angeordnet. Alternativ kann auch jeweils ein Bereich auf der Rückseite und den beiden Seitenflächen bereitgestellt werden. Somit kann eine effiziente Abstrahlung in verschiedene Raumrichtungen gewährleistet werden.

Gemäß einer weiteren vorteilhaften Ausführungsform umfasst das antistatische Material einen Kunststoff mit Füllstoffen zum Hervorrufen der antistatischen Eigenschaft. Somit wird ein leichtes Verarbeiten ermöglicht und ein günstiges Material für ein tragbares elektronisches Gerät kann verwendet werden, das weiterhin unempfindlich gegen Nässe, Staub und Stößen ist.

Gemäß einer weiteren vorteilhaften Ausführungsform ist der Widerstand des antistatischen Materials kleiner als 10¹¹ Ohm und bevorzug kleiner als 10⁹ Ohm. Somit wird ein antistatisches Material gewählt, das einen Widerstand besitzt, der kleiner ist als der des anderen Materials der zwischen den Rahmenelementen befindlichen Bereiche, und ein Aufladen des Gehäuses wird derart unterdrückt, dass einzelnen Ladungen keine Gefährdung in beispielsweise einer explosionsgefährdeten Umgebung darstellen.

Gemäß einer anderen Ausführungsform bilden die Rahmenelemente, d.h. alle Rahmenelemente der Rahmenstruktur des Geräts ein zusammenhängendes Netz, das eine durchgängige Leitfähigkeit zwischen den Rahmenelementen bewirkt. Somit kann sich keine Ladung auf einzelnen Elementen ansammeln und insbesondere keine Potenzialunterschiede bewirken.

Gemäß einer anderen Ausführungsform ist die Rahmenstruktur derart ausgebildet, dass ein Benutzer bei normaler Benutzung des tragbaren elektronischen Geräts in Kontakt mit mindestens einem Rahmenelement kommt. Beispielsweise werden Rahmenelemente auf der Rückseite, eines Geräts, die in der Hand eines Benutzers liegt oder Rahmenelemente an einem Handgriff des Geräts vorgesehen. Somit kann ein geerdeter Benutzer gleichzeitig auch das Gehäuse des Geräts erden, indem Ladungen von diesem abgeführt werden können.

Gemäß einer anderen vorteilhaften Ausführungsform stellt das Gerät mindestens eines dar von einem tragbaren Computer oder Laptop, einem persönlichen digitalen Assistenten (PDA), einem Mobiltelefon, einem Mess- und/oder Kalibrierungsgerät, einem Barcode-Scanner, einer Digitalkamera und einem Tablet-Computer. Demgemäß können verschiedene tragbare elektronische Geräte gemäß der erfinderischen Lehre angepasst werden und in explosionsgefährdeten Umgebungen sicher verwendet werden.

Eine weitere Ausführungsform betrifft ein Verfahren zur Herstellung eines tragbaren elektronischen Geräts zur Verwendung in explosionsgefährdeten Bereichen mit Schutz vor statischer Aufladung, umfassend die Schritte Bereitstellen eines tragbaren elektronischen Geräts mit Sendemodul, Antenne und einem Gehäuse zum Schutz vor statischen Entladungen, und Aufbringen auf mindestens einem Teil des Gehäuses einer Rahmenstruktur von Rahmenelementen (130, 135) aus antistatischem Material mit dazwischen befindlichen Bereichen (140, 141, 142) ohne Material oder eines anderen Materials, wobei die Abstrahlung der Antenne und die Rahmenstruktur derart aufeinander abgestimmt werden, dass eine Hauptstrahlungsrichtung durch einen Bereich mit dem anderen Material geht, und die Größe jedes Bereichs maximal 20 cm2 gewählt wird und das Gehäuse mindestens drei Bereiche des anderen Materials umfasst.

Weitere vorteilhafte Merkmale der Erfindung werden in der detaillierten Beschreibung der Ausführungsformen und in den Ansprüchen offenbart.

### Kurze Beschreibung der Zeichnungen

Im Folgenden wird die Erfindung ausführlich anhand der beigefügten Zeichnungen beschrieben.
Figuren 1a und 1b zeigen eine Seiten- bzw. Rückansicht eines tragbaren elektrostatischen Geräts gemäß einer Ausführungsform.
Figur 2 zeigt ein Sendemodul mit Antenne eines tragbaren elektronischen Geräts.
Figur 3 zeigt die Abstrahlungscharakteristik der Antenne bzw. Antennen der Figur 2.
Figur 4 zeigt die Abstrahlungscharakteristik von Antennen eines Sendemoduls in einem Gehäuse.
Figur 5 zeigt ein Gehäuse mit einer Rahmenstruktur von Rahmenelementen aus antistatischem Material gemäß einer Ausführungsform.
Figur 6 zeigt wie die Rahmenstruktur des Gehäuses von Figur 5 passend zur Abstrahlungscharakteristik der Antennenabstrahlungen von Figuren 3 und 4 gewählt wird.

### Ausführliche Beschreibung der bevorzugten Ausführungsformen

Bevorzugte Ausführungsformen der vorliegenden Erfindung werden nachfolgend ausführlich unter Bezugnahme auf die begleitenden Zeichnungen beschrieben. Dabei sind in den verschiedenen Zeichnungen gleiche oder entsprechende Elemente jeweils mit den gleichen oder ähnlichen Bezugszeichen bezeichnet.

Die bevorzugten Ausführungsformen der Erfindung, die im Folgenden detailliert beschrieben werden, werden ausführlich mit Bezug auf ein tragbares elektronisches Gerät mit sechs Seitenflächen und einem Sendemodul beschrieben. Jedoch wird bemerkt, dass die vorliegende Beschreibung nur Beispiele enthält und nicht als die Erfindung einschränkend angesehen werden sollte. Beispielsweise kann das tragbare elektronische Gerät auch andere Gehäuseformen mit einer anderen Anzahl von Seitenflächen aufweisen und mehrere Sendemodule oder ein Sende-und Empfangsmodul sowie eine beliebige Anzahl von Antennen enthalten.

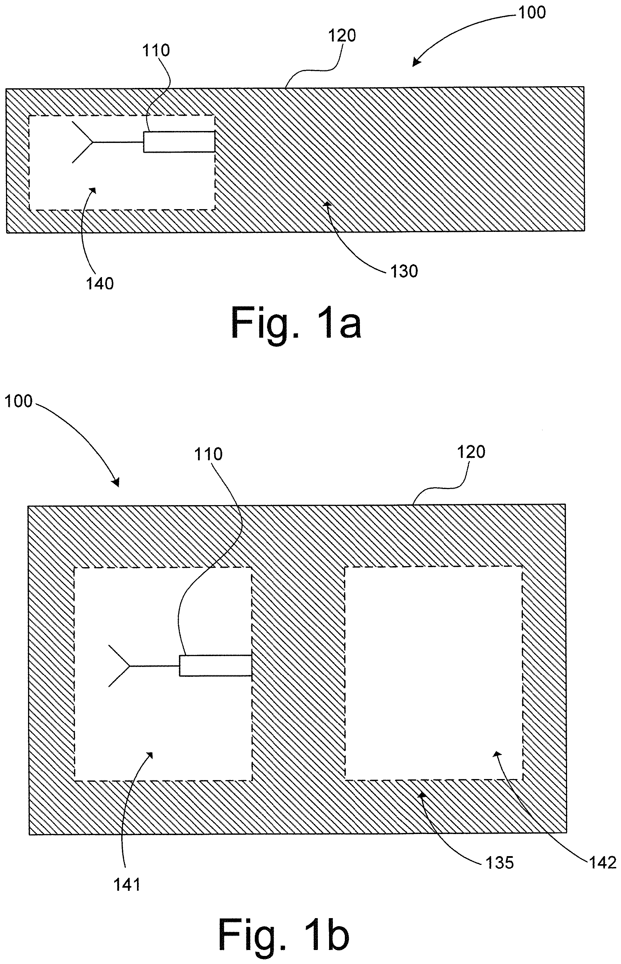

Figuren 1a und 1b zeigen eine Seitenansicht bzw. Rückseitenansicht eines elektronischen Geräts 100. Durch die schraffierten und nicht-schraffierten Flächen werden unterschiedliche Materialien im Aufbau des Gehäuses 120 des elektronischen Geräts 100 dargestellt, was im Folgenden näher erläutert wird.

Im Einzelnen zeigt Figur 1a Elemente eines tragbaren elektronischen Geräts zur Verwendung in explosionsgefährdeten Umgebungen. Der Aufbau des Geräts bietet einen Schutz vor statischer Aufladung. Dafür wird ein Gehäuse verwendet, das Rahmenelemente aus antistatischem Material aufweist. Wie gezeigt, umfasst das Gerät 100 ein Sendemodul 110, das auch als Sende- und Empfangsmodul (Transceiver-Modul) ausgebildet sein kann. Dieses Modul 110 weist eine Antenne auf zum Kommunizieren mit anderen Geräten, wie beispielsweise zum Übertragen von Daten an einen Computer oder Empfangen von Anweisungen von einem Computer.

In Figur 1a ist das Gehäuse 120 von einer Seitenansicht gezeigt. Auf dieser gezeigten Seite weist das Gehäuse eine Rahmenstruktur mit einem Rahmenelement 130 (in Figur 1a schraffiert), das aus antistatischem Material besteht, und einem Bereich 140 (der transparent gezeichnet ist), der aus einem anderen Material besteht, auf. Wie gezeigt, ist der andere Bereich derart angeordnet, dass eine mögliche Abstrahlung einer mit dem Sendemodul verbundenen Antenne durch diesen Bereich gehen kann.

Ähnlich dazu zeigt die in Figur 1b gezeigte Rückansicht des Geräts 100, dass das Gehäuse 120 auch ein Rahmenelement 135 als Teil der Rahmenstruktur aufweist, das aus antistatischem Material besteht sowie zwischen dem Rahmenelement befindliche Bereiche 141, 142. Da die Bereiche 141, 142 transparent gezeichnet sind, wie in Figur 1a, ist auch ersichtlich, dass ein Sendemodul 110 mit einer Antenne derart im Gehäuse angeordnet ist, dass eine Abstrahlung der Antenne durch insbesondere den linken Bereich 141 gehen kann.

Aus Figuren 1a und 1b wird ersichtlich, dass mindestens ein Teil des Gehäuses 120 eine derartige Rahmenstruktur von Rahmenelementen 130, 135 aus antistatischem Material mit dazwischen befindlichen Bereichen 140, 141, 142 eines anderen Materials aufweist, dass die Abstrahlung der Antenne des Sendemoduls 110 im Wesentlichen durch die Bereiche 140, 141 geht und nicht durch die Rahmenelemente aus antistatischem Material. Aufgrund der Positionierung der Antenne in diesem Beispiel, wird auch ersichtlich, dass der Bereich 142 weggelassen werden kann, d.h. der Bereich könnte auch durch antistatisches Material ersetzt werden.

Insbesondere kann sich die Rahmenstruktur über alle Seiten des tragbaren elektronischen Geräts 100 erstrecken und aus mehreren Rahmenelementen, z.B. Seitenelementen, aus antistatischem Material bestehen. Dadurch wird eine netzartige Struktur um das Gerät gebildet. Die Bereiche, die zwischen den Rahmenelementen liegen, d.h. von antistatischem Material freigelassene Bereiche, bestehen aus einem anderen Material, das keine oder nur viel geringere antistatische Eigenschaften im Vergleich zu den Rahmenelementen aufweist und dadurch Fenster zur Abstrahlung von elektromagnetischen Wellen bildet.

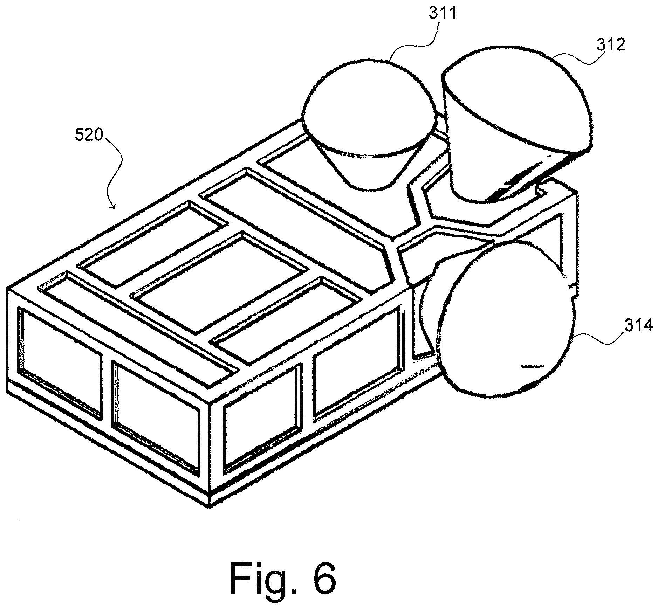

Dieses andere Material ist beispielsweise ein normaler für Gehäuse von elektronischen Geräten verwendeter Kunststoff, der im Wesentlichen für elektromagnetische Strahlung mit Frequenzen, die in der Kommunikationstechnik verwendet werden, durchlässig ist. Wie gezeigt, sind die Rahmenelemente derart angeordnet, dass sie die Abstrahlung nur unwesentlich beeinflussen, was im Folgenden noch genauer mit Bezug auf Figur 6 gezeigt wird.

Im Gegensatz dazu handelt es sich bei dem antistatischen Material um ein Material, das einen geringeren Widerstand aufweist als das andere Material und somit für Ladungen weitgehend leitend ist, so dass diese abgeführt werden können, wodurch sich keine oder nur eine minimale Oberflächenladung bilden kann. Diese antistatische Eigenschaft, d.h. eine Vermeidung der statischen Aufladung, kann beispielsweise durch einen Füllstoff in einem Kunststoff erreicht werden.

In einer Ausführungsform wird ein antistatisches Material aus einem Kunststoff mit Füllstoffen zum Hervorrufen der antistatischen Eigenschaft erhalten. Als Füllstoffe können beispielsweise Ruß oder verschiedene Salze verwendet werden, wodurch sich auch leicht der Widerstand des antistatischen Materials je nach Dosierung des Füllstoffs einstellen lässt.

Der Widerstand des antistatischen Materials sollte kleiner als 10¹¹ Ohm gewählt werden und bevorzugt kleiner als 10⁹ Ohm. Die zu wählenden Widerstandswerte sind dabei abhängig von der Anwendungsumgebung. So hat sich gezeigt, dass bei hoher Luftfeuchtigkeit ein Widerstand mit 10¹¹ Ohm ausreichend ist, die oben beschriebene Schutzfunktion zu erfüllen. Anderseits sollte bei niedrigeren Luftfeuchtigkeiten, oder falls diese stark schwankt, höchstens ein Widerstand von ungefähr 10⁹ Ohm gewählt werden. Natürlich kann bei Wahl eines geringen oder geringeren Widerstands als 10⁹ Ohm auch ein grobmaschigeres Netz, d.h. Rahmenstruktur, verwendet werden. In anderen Worten wählt der Entwickler einen guten Kompromiss zwischen Widerstand des antistatischen Materials und Größe der dazwischen befindlichen Bereiche, auf die im Folgenden noch näher eingegangen wird.

Im Gegensatz zum Widerstand des antistatischen Materials kann der Widerstand des anderen Materials, das bevorzugt auch ein Kunststoff ist, aufgrund der Rahmenstruktur größer sein als 10¹² Ohm und liegt normalerweise im Bereich von 10¹² bis 10¹⁵ Ohm.

Um eine sich auf den anderen Bereichen ansammelnde Flächenladung wirksam zu begrenzen, ist die Größe jedes zwischen Rahmenelementen liegenden Bereichs nicht größer als, d.h. maximal, 20 cm² gewählt. Es hat sich gezeigt, dass diese Bereichsgröße einen wirksamen Schutz vor Entladungen insbesondere im Ex-Bereich der Zone 1 bietet. Dies bedeutet, dass beispielsweise bei tragbaren Computern (Laptops) mehrere Bereiche mit einer Größe von bis zu 20 cm² vorkommen können, um einen wirksamen Schutz vor statischer Aufladung bereitzustellen. Diese Bereiche dürfen jedoch nicht miteinander verbunden sein, so dass durch deren Trennung sichergestellt wird, dass sich Flächenladungen einzelner Bereiche nicht addieren. Durch die Notwendigkeit des Auseinanderhaltens bzw. Isolierens von einzelnen Bereichen werden Rahmenelemente bereitgestellt, die netzartig das Gehäuse bedecken und einzelne Fenster aus dem anderen Material Bereiche von begrenzter Größe erlauben.

Falls sehr hohe Ansprüche an die Vermeidung der Aufladung eines Bereiches gestellt werden, wie in hochexplosiven Umgebungen oder/und der Widerstand des antistatischen Materials im oben beschriebenen höheren Bereich ist, können die Bereiche auch bevorzugt maximal 4 cm² gewählt werden. Der Vorteil bei der netzartigen Ausbildung der Rahmenstruktur des Gehäuses ist dabei, dass beliebige Bereichsgrößen leicht hergestellt werden können.

Wie mit Bezug auf Figuren 1a und 1b beschrieben, umfasst das Gehäuse mindestens drei Bereiche des anderen Materials. Beispielsweise können zwei Bereiche auf der Rückseite des Gehäuses vorgesehen werden, wie in Figur 1b gezeigt. Des Weiteren kann auch jeweils ein Bereich auf jeweils einer der zwei Seitenflächen bereitgestellt werden, wie in Figur 1a gezeigt. Um mehrere Raumrichtungen abzudecken, ist es gemäß Figuren 1a und 1b auch möglich, jeweils auf beiden Seitenflächen einen Bereich 140 vorzusehen und auf der Rückseite des Gehäuses einen Bereich 141, so dass drei Bereiche des anderen Materials eine nahezu unbeschränkte Abstrahlung in mindestens einem 180° Bereich ermöglichen. Der Einfluss auf die Abstrahlung der zwei Rahmenelemente, die den 180° Bereich in drei Bereiche aufteilen, ist vernachlässigbar.

Je nachdem wie viele Empfangs- bzw. Sendemodule und Antennen verwendet werden oder bei komplizierten Abstrahleigenschaften ist es vorteilhaft, mehrere Bereiche auf der Rückseite des Geräts, z.B. zwei, und/oder mehrere Bereiche an den Seitenflächen des Geräts anzuordnen. Natürlich können solche Bereiche auch an der Oberseite und Unterseite oder auch an der Vorderseite des Geräts angeordnet werden.

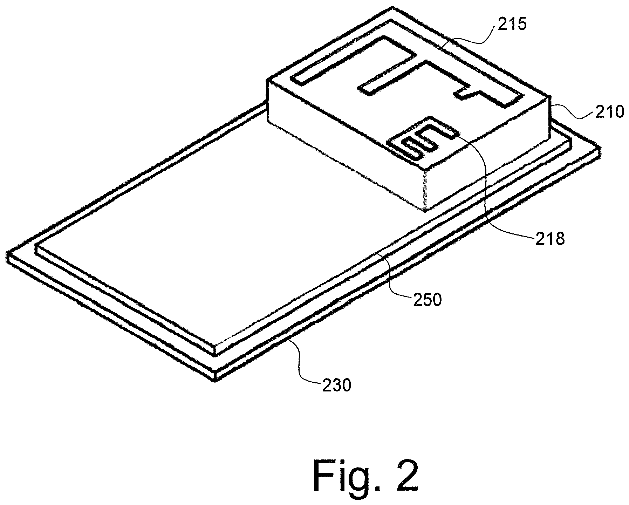

Figur 2 zeigt ein konkretes Beispiel eines Sendemoduls 210 mit zwei Antennen 215 und 218, das von dem Gehäuse des oben beschriebenen tragbaren elektronischen Geräts aufgenommen werden kann. In diesem Beispiel ist das Sendmodul 210 auf einem Träger 250, z.B. einer Platine, angebracht. Dieser Träger 250 liegt wiederum auf einer Platte 230, die beispielsweise einen Teil des Gehäuses, z.B. die Vorderseite des Gehäuses, bildet. In diesem Beispiel wird eine PIF-Antenne (*Planar Inverted F-Shaped Antenna*) verwendet, welches eine kompakte Antenne ist, die unter anderem in Mobilfunktelefonen eingesetzt wird, und klein, flach, effektiv und günstig herzustellen ist. Diese Antennenart eignet sich somit zur Verwendung in tragbaren elektronischen Geräten.

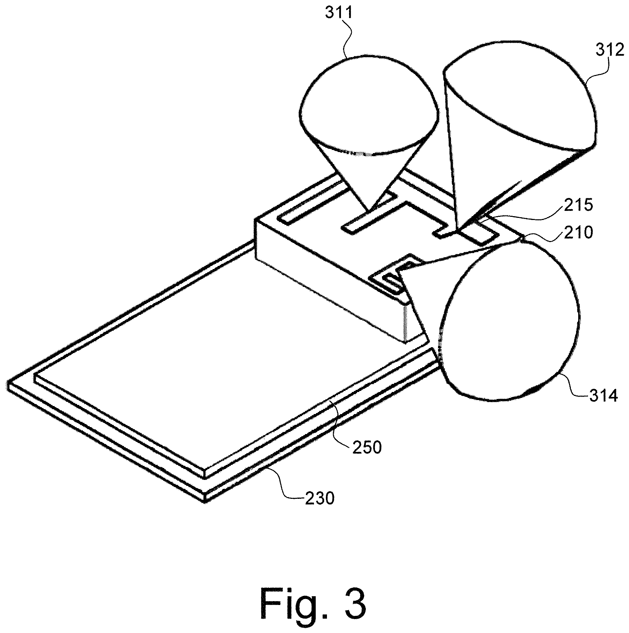

In Figur 3 werden verschiedene Abstrahlungseigenschaften der in Figur 2 gezeigten Antennen dargestellt. Hierbei handelt es sich insbesondere um Hauptabstrahlrichtungen bzw. Hauptkeulen dieser Antennen. Die Keulen 311 und 312 sind der Antenne 215 zugeordnet und die Keule 314 ist der Antenne 218 zugeordnet.

Der Fachmann erkennt, dass die Abstrahlcharakteristik in den Figuren zur Illustration übertrieben dargestellt ist und normalerweise nicht derart stark gerichtet ist sondern eher Kartoffel- bzw. Ei-förmig ist. Es soll jedoch verstanden werden, dass an einigen Positionen eine Abstrahlung auch nicht notwendig bzw. nicht erwünscht ist, und daher auch dort das antistatische Material vorgesehen werden kann, wie beispielsweise an dem Lautsprecherteil/Hörerteil eines Mobiltelefons.

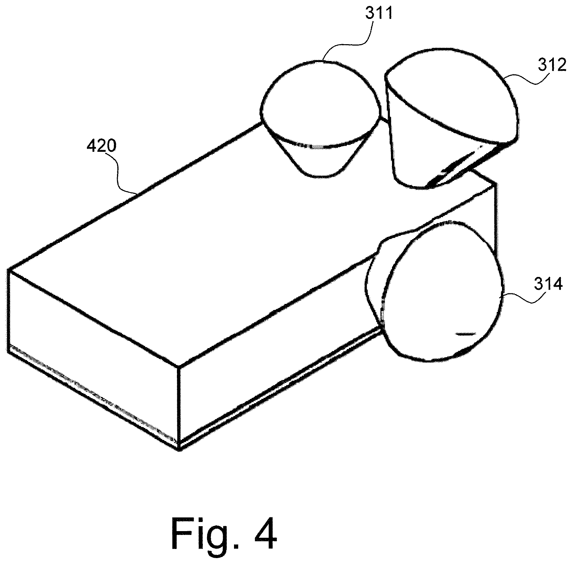

In Figur 4 wird ein vollständiges die Antennen und Sendemodul aufnehmendes Gehäuse 420 gezeigt, und es wird gezeigt, wie die Abstrahlung durch ein solches Gehäuse erfolgen würde. Unter der Annahme, dass das Gehäuse 420 vollständig aus einem antistatischen Material gefertigt ist, würde es zu signifikanten Abschwächungen bzw. Dämpfungen der abgestrahlten elektromagnetischen Wellen kommen, was zu den oben beschriebenen Funktionseinbußen führen kann. Beispielsweise würde die Reichweite des Funksignals drastisch verkürzt und durch die Abschwächung das Signal-zu-RauschVerhältnis verschlechtert, was zu fehlerhafter Übertragung von Daten führen würde.

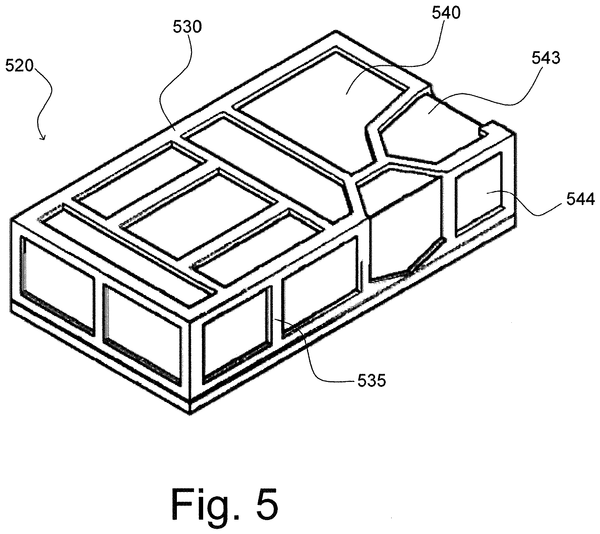

Figur 5 zeigt eine Rahmenstruktur eines Gehäuses eines tragbaren elektronischen Geräts gemäß einer Ausführungsform der Erfindung. Verschiedene Rahmenelemente 530 sind auf der Rückseite, Unterseite und Seitenfläche gezeigt. Insbesondere sind in Figur 5 mehrere zwischen den Rahmenelementen befindliche Bereiche, z.B. die Bereiche 540, 543, 544, vorgesehen, die aus einem Material bestehen, das elektromagnetische Wellen ohne merkliche Abschwächungen durchlässt.

Die Rahmenstruktur aus den Rahmenelementen 530 und 535 bildet ein zusammenhängendes Netz, d.h. die Rahmenelemente sind alle miteinander verbunden. Somit wird eine durchgängige Leitfähigkeit zwischen den Rahmenelementen bewirkt, so dass Ladungen abgeleitet werden können, und Ladungen können sich nicht auf einzelnen Elementen ansammeln, wodurch Potenzialunterschiede zwischen den Elementen entstehen könnten. Zudem sind die Bereiche derartig dimensioniert, dass sie jeweils nicht größer als 20 cm² sind, wodurch die mögliche Oberflächenladung auf den Bereichen begrenzt wird.

Aus der gezeigten Art der Rahmenstruktur ist sofort ersichtlich, dass ein Benutzer bei normaler Benutzung des tragbaren elektronischen Geräts, d.h. beim In-die-Hand-nehmen des Gehäuses 520, der Benutzer in Kontakt mit mindestens einem Rahmenelement kommt. Da diese Rahmenelemente jedoch alle miteinander verbunden sind, kann der Benutzer als Erdung des Gehäuses fungieren, was insbesondere vorteilhaft ist, wenn der Benutzer selbst geerdet ist.

Durch die Verwendung von Kunststoff für das Gehäuse können einfache Spritzgussverfahren verwendet werden, um beliebige Rahmenstrukturen zu erzeugen, die somit beliebig anpassbar sind auf Abstrahlungseigenschaften der verwendeten Antennen im Gerät. Beispielsweise kann zuerst der Teil des Gesamtgehäuses 520, der aus dem anderen Material besteht, hergestellt werden und danach dieser überzogen werden mit der in Figur 5 gezeigten Rahmenstruktur, die auf den Bereichen sich ansammelnde Ladung aufgrund ihres niedrigeren Widerstands abführen kann.

In Figur 6 werden die Abstrahlungskeulen 311, 312 und 314 der Figuren 3 und 4 dem Gehäuse 520 der Figur 5 überlagert. Dabei zeigt sich, dass die Rahmenstruktur mit Rahmenelementen 530 und 535 aus Figur 5 derart passend gewählt wurde, dass die Abstrahlungskeulen hauptsächlich durch die nichtantistatischen Bereiche gehen, und dadurch nicht durch die Rahmenelemente negativ beeinflusst werden. Mit anderen Worten ausgedrückt, sind die Abstrahlungen der Antenne oder Antennen und die Rahmenstruktur derart aufeinander abgestimmt, dass eine Hauptstrahlungsrichtung, z.B. die Hauptkeule, durch einen Bereich mit dem anderen Material geht.

Somit besteht eine Abhängigkeit zwischen der Antennenform und den daraus resultierenden Abstrahlungseigenschaften der Antenne und der Art der zu verwendeten Rahmenstruktur für das Gehäuse. Daher muss der Entwickler des Geräts die Anforderungen der Funktechnik (Positionierung der Antenne und deren Abstrahlungseigenschaften) und die der Antistatik in Betracht ziehen.

Aus der vorangegangenen Diskussion wird deutlich, dass es auch möglich ist, insbesondere durch Kenntnis der Abstrahlungseigenschaften der Antenne und der Möglichkeit der einfachen Herstellung einer Rahmenstruktur aus antistatischem Material, eine für existierende Geräte, die nicht mit einem Schutz vor statischer Aufladung versehen sind, entsprechende Rahmenstruktur zu fertigen, die dann auf einem existierenden Gehäuse des Geräts aufgebracht werden kann.

Demgemäß kann ein Nachrüstungsprozess verwendet werden zur Herstellung eines tragbaren elektronischen Geräts mit Schutz vor statischer Aufladung. Dabei wird in einem ersten Schritt ein herkömmliches tragbares elektronisches Gerät mit Sendemodul, Antenne und Gehäuse bereitgestellt sowie eine Rahmenstruktur, die netzartig mit Rahmenelementen aus antistatischem Material und dazwischen befindlichen Bereichen ohne Material oder mit Material einer geringeren Leitfähigkeit, d.h. größerem Widerstand, ausgebildet ist.

Danach wird die Rahmenstruktur auf mindestens einem Teil des Gehäuses aufgebracht, z.B. durch Kleben oder Schrauben oder durch einfaches Überspannen über das Gehäuse. Dabei wird die Rahmenstruktur aus Rahmenelementen aus antistatischem Material mit dazwischen befindlichen Bereichen ohne Material oder eines anderen Materials derart auf dem Gehäuse angeordnet, dass die Abstrahlung der Antenne im Wesentlichen durch die Bereiche geht und nicht durch die Rahmenelemente aus antistatischem Material. Beispielsweise werden im Bereich der Antenne weniger und schmalere Rahmenelemente verwendet als an anderen Positionen. Verschiedene Materialien wie bestimmte Folien oder entsprechend auf den Widerstand angepasste Kunststoffe können zur Herstellung der Rahmenstruktur verwendet werden.

Tragbare elektronische Geräte, die sinnvollerweise ein Gehäuse gemäß den obigen Ausführungen aufweisen sollten oder dementsprechend nachgerüstet werden können, umfassen tragbare Computer oder Laptops, persönliche digitale Assistenten, Mobiltelefone, Mess- und/oder Kalibrierungsgeräte, Barcode-Scanner, Digitalkameras und Tablet-Computer.

Beispielsweise ist die Verwendung von Barcode-Scannern auch in Fabriken mit explosionsgefährdeten Umgebungen gewünscht, wobei der Barcode-Scanner einen Barcode in der Produktion erfassen kann, und die entsprechenden ausgelesenen Informationen sofort drahtlos durch eine elektromagnetische Welle an ein Computersystem in Echtzeit senden kann, z.B. über WLAN, Bluetooth oder eine andere Kommunikationstechnologie. Das gleiche gilt für Messdaten, die von Mess- und/oder Kalibrierungsgeräten erfasst werden und zur Echtzeit- oder Nahe-Echtzeitverarbeitung an ein Computersystem übertragen werden müssen.

Aus der vorangehenden Beschreibung erkennt der Fachmann, dass verschiedene Modifikationen und Varianten des Geräts möglich sind, ohne den Umfang der durch die Ansprüche definierten Erfindung zu verlassen. Ferner wurde die Erfindung mit Bezug auf bestimmte Beispiele beschrieben, die jedoch nur zum besseren Verständnis der Erfindung dienen sollen, und diese nicht einschränken sollen. Der Fachmann erkennt auch sofort, dass viele verschiedene Kombinationen der beschriebenen Elemente zur Ausführung der vorliegenden Erfindung verwendet werden können, wobei die Erfindung durch die folgenden Ansprüche definiert ist.

## Patentansprüche

1. Tragbares elektronisches Gerät zur Verwendung in explosionsgefährdeten Bereichen, mit Schutz vor statischer Aufladung, umfassend
ein Sendemodul (110) mit einer Antenne, und
ein Gehäuse zum Schutz vor statischen Entladungen (120), das das Sendemodul und die Antenne aufnimmt, wobei
mindestens ein Teil des Gehäuses eine Rahmenstruktur von Rahmenelementen (130, 135) aus antistatischem Material mit dazwischen befindlichen Bereichen (140, 141, 142) eines anderen Materials aufweist, und
die Abstrahlung der Antenne und die Rahmenstruktur derart aufeinander abgestimmt sind, dass eine Hauptstrahlrichtung durch einen Bereich mit anderem Material geht, und
wobei die Größe jedes Bereichs maximal 20 cm² ist und
das Gehäuse mindestens drei Bereiche des anderen Materials umfasst.

2. Tragbares elektronisches Gerät nach Anspruch 1, wobei mindestens zwei Bereiche an der Rückseite des Geräts und/oder zwei Bereiche an den Seitenflächen des Geräts angeordnet sind.

3. Tragbares elektronisches Gerät nach einem der Ansprüche 1 bis 2, wobei das antistatische Material ein Kunststoff mit Füllstoffen zum Hervorrufen der antistatischen Eigenschaft ist.

4. Tragbares elektronisches Gerät nach einem der Ansprüche 1 bis 3, wobei die Rahmenelemente der Rahmenstruktur des Geräts ein zusammenhängendes Netz bilden, das eine durchgängige Leitfähigkeit zwischen den Rahmenelementen bewirkt.

5. Tragbares elektronisches Gerät nach einem der Ansprüche 1 bis 4, wobei die Rahmenstruktur derart ausgebildet ist, dass ein Benutzer bei Benutzung des tragbaren elektronischen Geräts in Kontakt mit mindestens einem Rahmenelement kommt.

6. Tragbares elektronisches Gerät nach einem der Ansprüche 1 bis 5, wobei das Gerät mindestens eines darstellt von einem tragbaren Computer oder Laptop, einem Persönlichen Digitalen Assistenten, einem Mobiltelefon, einem Mess- und/oder Kalibrierungsgerät, einem Barcode-Scanner, einer Digitalkamera und einem Tablet-Computer.

7. Verfahren zur Herstellung eines tragbaren elektronischen Geräts zur Verwendung in explosionsgefährdeten Bereichen mit Schutz vor statischer Aufladung, umfassend die Schritte:
Bereitstellen eines tragbaren elektronischen Geräts mit Sendemodul, Antenne und einem Gehäuse zum Schutz vor statischen Entladungen, und
Aufbringen auf mindestens einem Teil des Gehäuses einer Rahmenstruktur von Rahmenelementen (130, 135) aus antistatischem Material mit dazwischen befindlichen Bereichen (140, 141, 142) ohne Material oder eines anderen Materials, wobei die Abstrahlung der Antenne und die Rahmenstruktur derart aufeinander abgestimmt werden, dass eine Hauptstrahlungsrichtung durch einen Bereich mit dem anderen Material geht, und die Größe jedes Bereichs maximal 20 cm² gewählt wird und das Gehäuse mindestens drei Bereiche des anderen Materials umfasst.

## Claims

1. Portable electronic device for use in potentially explosive areas, with protection against static charge, comprising
a transmitter module (110) having an antenna, and
a housing for protection against static discharges (120), which accommodates the transmitter module and the antenna, wherein
at least one part of the housing has a frame structure of frame elements (130, 135) made of antistatic material, with areas (140, 141, 142) disposed therebetween that are made of another material, and
the radiation of the antenna and the frame structure are adjusted to each other in such a way that a main radiation direction passes through an area with another material, and
wherein the size of each area is a maximum of 20 cm² and
the housing comprises at least three areas made of the other material.

2. Portable electronic device according to claim 1, wherein at least two areas are arranged on the rear side of the device and/or two areas are arranged on the side surfaces of the device.

3. Portable electronic device according to one of claims 1 to 2, wherein the antistatic material is a plastic with fillers for inducing the antistatic property.

4. Portable electronic device according to one of claims 1 to 3, wherein the frame elements of the frame structure of the device form an interconnected network that provides continuous conductivity between the frame elements.

5. Portable electronic device according to one of claims 1 to 4, wherein the frame structure is configured in such a way that a user comes into contact with at least one frame element when using the portable electronic device.

6. Portable electronic device according to one of claims 1 to 5, wherein the device is at least one of a portable computer or laptop, a Personal Digital Assistant, a mobile phone, a measuring and/or calibration device, a barcode scanner, a digital camera and a tablet computer.

7. Method for manufacturing a portable electronic device for use in potentially explosive areas, with protection against static charge, comprising the steps of:
providing a portable electronic device having a transmitter module, an antenna and a housing for protection against static discharges, and
applying onto at least one part of the housing a frame structure of frame elements (130, 135) made of antistatic material, with areas (140, 141, 142) disposed therebetween without material or another material, wherein the radiation of the antenna and the frame structure are adjusted to each other in such a way that a main radiation direction passes through an area with the other material, and the size of each area is a maximum of 20 cm² and the housing comprises at least three areas made of the other material.

## Revendications

1. Appareil électronique portable destiné à être utilisé dans des zones à risque d'explosion, doté d'une protection contre la charge électrostatique, comprenant
un module d'envoi (110) avec une antenne, et
un boîtier de protection contre les décharges électrostatiques (120), qui accueille le module d'envoi et l'antenne, dans lequel
au moins une partie du boîtier présente une structure de châssis d'éléments de châssis (130, 135) en matériau antistatique avec des zones intercalées (140, 141, 142) d'un autre matériau, et
le rayonnement de l'antenne et la structure de châssis sont adaptés l'un à l'autre de telle manière qu'une direction de faisceau principal traverse une zone avec un autre matériau, et
dans lequel la taille de chaque zone est au maximum de 20 cm² et
le boîtier comprend au moins trois zones de l'autre matériau.

2. Appareil électronique portable selon la revendication 1, dans lequel au moins deux zones sont disposées sur le côté arrière de l'appareil et/ou deux zones sont disposées sur les faces latérales de l'appareil.

3. Appareil électronique portable selon l'une quelconque des revendications 1 à 2, dans lequel le matériau antistatique est une matière plastique avec des charges destinées à provoquer la propriété antistatique.

4. Appareil électronique portable selon l'une quelconque des revendications 1 à 3, dans lequel les éléments de châssis de la structure de châssis de l'appareil forment un réseau continu, qui entraîne une conductivité constante entre les éléments de châssis.

5. Appareil électronique portable selon l'une quelconque des revendications 1 à 4, dans lequel la structure de châssis est réalisée de telle manière qu'un utilisateur vient en contact avec au moins un élément de châssis lors de l'utilisation de l'appareil électronique portable.

6. Appareil électronique portable selon l'une quelconque des revendications 1 à 5, dans lequel l'appareil constitue au moins un d'un ordinateur portable, d'un assistant numérique personnel, d'un téléphone mobile, d'un appareil de mesure et/ou d'étalonnage, d'un scanner de code-barres, d'une caméra numérique et d'une tablette.

7. Procédé de production d'un appareil électronique portable destiné à être utilisé dans des zones à risque d'explosion, doté d'une protection contre la charge électrostatique, comprenant les étapes :
de fourniture d'un appareil électronique portable avec un module d'envoi, une antenne et un boîtier de protection contre les décharges électrostatiques, et
d'application sur au moins une partie du boîtier d'une structure de châssis d'éléments de châssis (130, 135) en matériau antistatique avec des zones intercalées (140, 141, 142) sans matériau ou d'un autre matériau, dans lequel le rayonnement de l'antenne et la structure de châssis sont adaptés l'un à l'autre de telle manière qu'une direction de faisceau principal traverse une zone avec l'autre matériau, et la taille sélectionnée de chaque zone est de 20 cm² au maximum et le boîtier comprend au moins trois zones de l'autre matériau.
